Europäisches Patentamt

European Patent Office

Office européen des brevets

(19)

(11) EP 0 718 965 A1

(12) DEMANDE DE BREVET EUROPEEN

(43) Date de publication:
26.06.1996 Bulletin 1996/26

(51) Int Cl.6: **H03F 1/30**, H03F 1/52, H03F 1/02

(21) Numéro de dépôt: 95402867.6

(22) Date de dépôt: 19.12.1995

(84) Etats contractants désignés:
CH DE FR GB IT LI

(30) Priorité: 23.12.1994 FR 9415581

(71) Demandeur: THOMCAST
F-78700 Conflans-Sainte-Honorine (FR)

(72) Inventeur: Michel, Jean, Thomson-CSF
F-92402 Courbevoie Cedex (FR)

(74) Mandataire: Courtellemont, Alain et al
THOMSON-CSF,
SCPI,
B.P. 329,
50, rue Jean-Pierre Timbaud
92402 Courbevoie Cédex (FR)

(54) **Amplificateur classe A en radiofréquences et émetteur équipé d'au moins un tel amplificateur**

(57) L'invention concerne les amplificateurs classe A, à transistors, fonctionnant en radiofréquences.

L'emballement thermique du transistor de puissance (T) de l'amplificateur est empêché par une boucle d'asservissement du courant moyen du collecteur avec, en série, des moyens de mesure (G, R2-R7) du courant collecteur et une source (T1, T2, R8-R10) de polarisation de la base. L'impédance de cette source est choisie aussi faible que possible afin que la tension de polarisation ne risque pas de varier au rythme du signal radiofréquence (E) et d'entraîner une modulation parasite.

Application aux émetteurs en radiofréquences.

FIG.4

## Description

La présente invention se rapporte aux amplificateurs classe A, à transistors, fonctionnant en radiofréquences et aux émetteurs équipés de tels amplificateurs.

Un transistor utilisé en classe A, en radiofréquences est exposé au phénomène d'emballement thermique, destructif si des précautions ne sont pas prises.

Pour éviter l'emballement thermique qui, par une augmentation incontrôlée du courant dans le transistor, aboutit à la destruction du transistor, il est connu de réaliser une boucle d'asservissement du courant moyen de collecteur du transistor qui comporte des moyens de mesure du courant collecteur du transistor suivis d'une source de courant et l'asservissement est effectué de manière que, sous la commande des moyens de mesure, le courant fourni par la source de courant à la base du transistor contrarie le phénomène d'emballement. Un schéma d'un amplificateur avec une telle boucle d'asservissement sera décrit plus loin. Il s'avère qu'avec ces amplificateurs selon l'art connu le fonctionnement est satisfaisant tant que le transistor est strictement utilisé dans la partie linéaire de sa caractéristique c'est-à-dire à condition que les caractéristiques des transistors soient largement dimensionnées pour le service demandé. Or cette condition n'est généralement pas remplie, en particulier avec les amplificateurs de puissance qui sont utilisés près du maximum de leurs possibilités pour des raisons évidentes de prix. Les non-linéarités font apparaître des variations des courants de base et de collecteur et il en résulte une modulation parasite du signal à transmettre; or les différents systèmes de correction sont incompétents pour y remédier.

La présente invention a pour but d'éviter ou, pour le moins, de réduire ces inconvénients.

Ceci a été obtenu en recherchant la cause profonde de ces inconvénients et en faisant le nécessaire pour l'écarter.

Selon l'invention il est proposé un amplificateur fonctionnant en classe A, en radiofréquences, comportant un transistor de puissance, avec une base sur laquelle est appliqué un signal radiofréquence à amplifier, un collecteur et un émetteur, et une boucle d'asservissement du courant de collecteur du transistor avec des moyens de mesure du courant de collecteur, caractérisé en ce qu'il comporte, dans la boucle, une source de tension commandée par les moyens de mesure pour délivrer, avec une impédance de source quasi nulle, une tension de polarisation de la base du transistor.

La présente invention sera mieux comprise et d'autres caractéristiques apparaîtront à l'aide de la description ci-après et des figures s'y rapportant qui représentent:

- la figure 1, le schéma électrique d'un exemple de réalisation d'un amplificateur selon l'art connu,
- la figure 2, un schéma de principe des amplificateurs selon l'art connu,
- la figure 3, un schéma de principe des amplificateurs selon l'invention,
- la figure 4, un schéma électrique d'un exemple de réalisation d'un amplificateur selon l'invention.

Sur les différentes figures les éléments correspondants sont désignés par les mêmes repères.

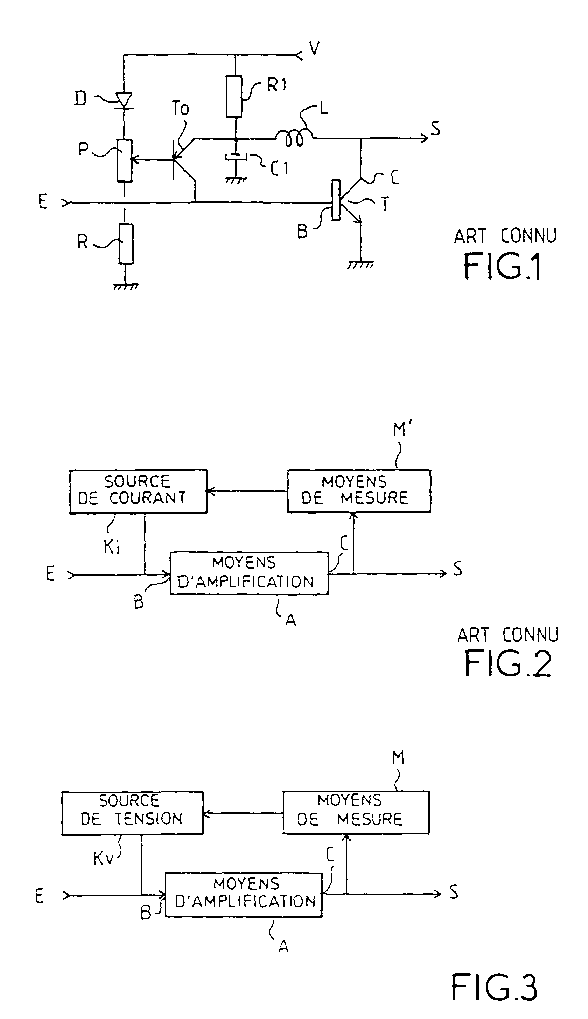

La figure 1 est le schéma électrique d'un amplificateur en classe A, selon l'art connu, avec un transistor npn de puissance, T, dont l'émetteur est à la masse, dont la base reçoit le signal radiofréquence à amplifier, E, et sur le collecteur duquel apparaît le signal radiofréquence amplifié, S ; ce dernier signal est fourni à une liaison dont le départ est représenté par un conducteur terminé par une tête de flèche et cette liaison aboutit à un circuit de charge non représenté via un circuit d'adaptation non représenté. Sur cette figure le circuit d'adaptation d'entrée, entre la source du signal radiofréquence et la base du transistor T, n'a pas été représenté.

Le collecteur du transistor T est couplé par une inductance L, communément appelée self de choc, à l'émetteur d'un transistor pnp, $T_o$, et à la première extrémité d'une résistance R1 dont la seconde extrémité est connectée à un point à potentiel constant V. Le collecteur du transistor $T_o$ est relié à la base du transistor T et sa base est reliée au curseur d'un potentiomètre de réglage P; une des extrémités du potentiomètre P est couplée à la masse par une résistance R et l'autre extrémité est reliée à la cathode d'une diode D dont l'anode est reliée au point à potentiel constant V. Un condensateur de découplage, C1, relie à la masse le point commun à la résistance R1 et à l'inductance L.

Le montage selon la figure 1 permet de maintenir constant le courant collecteur du transistor T et donc d'éviter le phénomène d'emballement thermique; en effet si le courant collecteur du transistor T, et donc le courant dans la résistance R1, venait à augmenter, la tension appliquée sur l'émetteur du transistor T1 diminuerait et, comme la tension appliquée sur la base du transistor T1 est constante, le courant fourni à la base du transistor T diminuerait, le transistor T serait donc moins passant c'est-à-dire qu'il s'opposerait à l'augmentation de son courant collecteur.

La boucle d'asservissement du montage selon la figure 1 peut se représenter comme indiqué sur la figure 2 où trois rectangles A, M' et Ki symbolisent respectivement des moyens d'amplification, des moyens de mesure et une source de courant. Les moyens d'amplification correspondent sensiblement au transistor T et les moyens de mesure sont la représentation de la surveillance, au niveau de l'émetteur du transistor $T_o$, de la chute de tension occasionnée par le courant dans la résistance R1 et donc de la surveillance du courant de collecteur du transistor T puisque la majeure partie du courant dans la résistance R1 se dirige vers le collecteur du transistor T; quant à la source de courant elle correspond sensiblement au transistor $T_o$ associé aux compo-

sants D, P, R.

Il est à observer que la tension de polarisation de la base du transistor T étant fournie par une source de courant, c'est-à-dire par une source dont l'impédance interne ne peut être négligée en radiofréquences, cette tension varie au rythme du signal radiofréquence appliqué sur la base du transistor T.

Le montage selon la figure 2 convient tant que le transistor radiofréquence est utilisé dans la partie rectiligne de sa caractéristique, c'est-à-dire tant que l'amplificateur est largement dimensionné pour le service qui lui est demandé.

Cette condition pour un bon fonctionnement est un luxe prohibitif dans le domaine des amplificateurs de puissance et, pour des raisons évidentes de réduction du coût, ces amplificateurs de puissance sont utilisés près du maximum de leurs possibilités.

Les non-linéarités font alors apparaître des variations des courants de base et de collecteur du transistor radiofréquence et l'analyse spectrale de ces courants montre, en particulier, des raies correspondant au signal modulant. Ainsi, lorsque les tensions de polarisation sont fournies par des sources dont l'impédance interne ne peut être négligée aux fréquences du signal à amplifier, ces tensions varient au rythme du signal à amplifier et donnent lieu à une nouvelle modulation du signal amplifié; cette nouvelle modulation est une modulation parasite que les différents systèmes de correction existants ne sont pas capables d'éviter.

C'est pourquoi, dans ce qui suit, il n'est pas question d'essayer de corriger cette modulation parasite mais d'éviter qu'elle n'apparaisse et, pour cela, d'utiliser des sources de polarisation de base et de collecteur ayant une impédance interne aussi faible que possible. Il est proposé, à cet effet, un amplificateur qui se distingue des amplificateurs classe A connus, par la substitution d'une source de tension à la source de courant. La figure 3 rend compte de cette substitution et se distingue pour cela de la figure 2 par le remplacement de la source de courant Ki par une source de tension Kv.

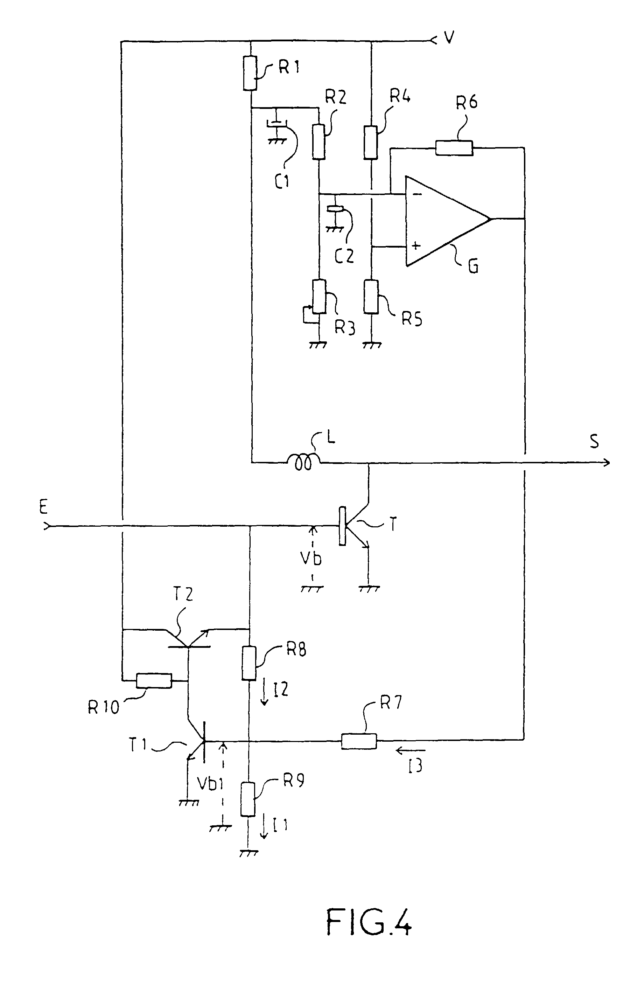

La figure 4 est un schéma électrique d'un exemple de réalisation d'un amplificateur de puissance en classe A selon l'invention. Ce schéma représente un transistor npn de puissance, T, dont l'émetteur est à la masse, dont la base reçoit le signal radiofréquence à amplifier, E, et sur le collecteur duquel apparaît le signal radiofréquence amplifié, S; ce dernier signal est fourni à une liaison dont le départ est représenté par un conducteur terminé par une tête de flèche et cette liaison aboutit à un circuit de charge non représenté via un circuit d'adaptation non représenté.

Le collecteur du transistor T est couplé par une inductance L, communément appelée self de choc, à la première extrémité d'une résistance R1, d'une résistance R2 et d'un condensateur C1. La seconde extrémité de la résistance R1 est connectée à un point à potentiel positif constant V. La seconde extrémité du condensateur C1 est reliée à la masse. La seconde extrémité de la résistance R2 est relie à la première extrémité d'une résistance ajustable R3 et d'un condensateur C2 et à l'entrée "-" d'un amplificateur opérationnel G. La seconde extrémité de la résistance R3 et du condensateur C2 est reliée à la masse.

L'entrée "+" de l'amplificateur G est reliée à la masse par une résistance R5 et au point à potentiel V par une résistance R4. Une résistance R6 relie entre elles l'entrée "-" et la sortie de l'amplificateur G.

La sortie de l'amplificateur G est couplée par une résistance de valeur élevée, R7, à la base d'un transistor npn, T1, et à la première extrémité d'une résistance R8 et d'une résistance R9. La seconde extrémité de la résistance R9 est reliée à la masse et la seconde extrémité de la résistance R8 est reliée à la base du transistor T.

Le transistor T1 a son émetteur relié à la masse et son collecteur relié à la base d'un transistor npn, T2, dont l'émetteur est relié à la base du transistor T et dont le collecteur est relié au point à potentiel positif constant V. Une résistance R10 relie entre eux le collecteur et la base du transistor T2.

Sur la figure 4 des références ont été attribuées à des courants et à des tensions: $I1$, $I2$, $I3$ pour les courants dans, respectivement, les résistances R9, R8, R7 et Vb, Vb1 pour les tensions entre la masse et, respectivement, les bases des transistors T et T1.

Avec le circuit selon la figure 1 le courant de base du transistor T contrarie le phénomène d'emballement thermique en maintenant constant le courant collecteur du transistor T. Avec le circuit selon la figure 4 le même résultat est atteint en faisant varier la tension Vb sur la base du transistor T.

La source de tension qui fournit la tension Vb et dont il a été question lors de la description de la figure 3 est, ici, réalisée par le transistor ballast T2 et la boucle de contre-réaction avec le transistor T1 et les résistances R8, R9, R10 ; la contre-réaction assure à l'impédance de source une valeur très faible, quasi nulle.

Il est à noter que le circuit constitué des éléments T1, T2, R8, R9, R10 est un circuit connu, généralement appelé multiplicateur de tension base-émetteur ou multiplicateur de Vbe du fait que, comme il apparaîtra dans ce qui suit, lorsque le courant $I3$ est nul, la tension Vb qu'il délivre est égale au produit de la tension base-émetteur, Vbe appelée Vb1 sur la figure 4, du transistor T1 par la coefficient $1 + \frac{R8}{R9}$.

La tension Vb est donnée par

$$Vb = Vb1 + R8, I2$$

où Vb1, tension base-émetteur du transistor T1, a une valeur constante de l'ordre de 0,6 V.

Le courant $I2$ peut s'écrire

$$I2 = I1 - I3$$

en profitant de ce que le courant base-émetteur du transistor T1 est infime devant le courant $I1$, pour le négliger. Dans cette formule $I1$ est une constante puisque égal à

$\frac{Vb1}{R9}$ et que Vb1 est constant comme indiqué ci-dessus. La tension Vb peut donc s'écrire

$$Vb = Vb1 + R8(I1\text{-}I3)$$
$$= Vb1 + \frac{R8}{R9} Vb1 - R8.I3$$
$$= Vb1(1 + \frac{R8}{R9}) - R8.I3$$

Vb1 étant constant comme il a été remarqué ci-avant, la tension Vb est une fonction linéaire de la variable I3 c'est-à-dire du courant fournit par l'amplificateur G.

L'amplificateur opérationnel G est un générateur de tension que la résistance R7, de valeur élevée, transforme en générateur de courant.

Lorsque la tension aux bornes de la résistance R1 augmente, la tension de commande du générateur G augmente, le courant I3 augmente corrélativement, le courant I2=I1-I3, avec I1 constant, diminue, la tension Vb=Vb1+R8.I2, avec Vb1 constante, diminue, ce qui entraîne une diminution du courant dans le collecteur du transistor T et donc une diminution de la tension aux bornes de R1 ; de même une diminution de la tension aux bornes de R1 entraîne, par contre-réaction, une augmentation de cette même tension. La boucle d'asservissement qui prélève sa tension d'entrée aux bornes de la résistance de collecteur R1, permet ainsi de commander la tension Vb qui maintient le courant moyen du transistor T à une valeur ajustée par la résistance R3 et cela avec une constante de temps déterminée par le condensateur C2 et son environnement résistif.

La présente invention n'est pas limitée à l'exemple décrit à l'aide de la figure 4, cette figure étant d'ailleurs un schéma réduit aux composants nécessaires à la compréhension du fonctionnement de l'invention ; ainsi, par exemple la source de tension, faite des composants T1, T2, R8, R9, R10 et qui, comme indiqué plus avant, est un circuit connu sous le nom de multiplicateur de Vbe, a été représentée sans compensation en température alors qu'une telle compensation est connue et ne pose donc pas de problème de réalisation.

En fait l'invention se rapporte à tout amplificateur à transistor fonctionnant en classe A en radiofréquences et conforme au schéma selon la figure 3 et à tout émetteur équipé d'au moins un tel amplificateur.

**Revendications**

1. Amplificateur fonctionnant en classe A, en radiofréquences, comportant un transistor de puissance (T), avec une base sur laquelle est appliqué un signal radiofréquence à amplifier (E), un collecteur et un émetteur, et une boucle d'asservissement du courant de collecteur du transistor avec des moyens de mesure (M) du courant de collecteur, caractérisé en ce qu'il comporte, dans la boucle, une source de tension (Kv) commandée par les moyens de mesure (M) pour délivrer, avec une impédance de source quasi nulle, une tension de polarisation (Vb) de la base du transistor (T).

2. Amplificateur selon la revendication 1, caractérisé en ce que les moyens de mesure (M) comportent un amplificateur opérationnel (G) ayant une entrée (-) couplée au collecteur du transistor (T) et une sortie couplée à travers une résistance (R7) à la source de tension (Kv) et en ce que la source de tension est réalisée à l'aide d'un circuit (T1, T2, R8, R9, R10) dit multiplicateur de tension base-émetteur (Vb1).

3. Emetteur en radiofréquences, caractérisé en ce qu'il est équipé d'au moins un amplificateur selon l'une des revendications précédentes.

ART CONNU
FIG.1

ART CONNU
FIG.2

FIG.3

5

FIG.4

Office européen
des brevets

**RAPPORT DE RECHERCHE EUROPEENNE**

Numero de la demande
EP 95 40 2867

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP-A-0 156 694 (THOMSON-LGT)<br>* page 1, ligne 3 - ligne 7; figure 2 *<br>* page 4, ligne 3 - page 7, ligne 2 *<br>--- | 1-3 | H03F1/30<br>H03F1/52<br>H03F1/02 |
| A | DE-A-30 20 313 (ROHDE & SCHWARZ GMBH)<br>* page 6, ligne 14 - page 8, ligne 25; figure 1 *<br>--- | 1,2 | |
| A | GB-A-1 323 640 (STANDARD TELEPHONES AND CABLES LTD)<br>* page 1, ligne 66 - page 2, ligne 23; figure 2 *<br>----- | 1,2 | |

DOMAINES TECHNIQUES
RECHERCHES (Int.Cl.6)

H03F

Le présent rapport a été établi pour toutes les revendications

| Lieu de la recherche | Date d'achèvement de la recherche | Examinateur |
|---|---|---|
| LA HAYE | 28 Février 1996 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)